# EUROPEAN PATENT SPECIFICATION

(11) **EP 1 943 738 B1**
(45) Date of publication and mention of the grant of the patent: **30.12.2009**
(21) Application number: 05796908.1
(22) Date of filing: 27.10.2005
(51) Int. Cl.: H04B 1/18, H03H 7/01, H03J 1/00

(54) **CALIBRATION DEVICE AND PROCESS WITH FORWARD/BACKWARD MECHANISM FOR A BAND-PASS FILTER.**
KALIBRIERUNGSEINRICHTUNG UND PROZESS MIT VORWÄRTS-/RÜCKWÄRTSMECHANISMUS FÜR EIN BANDPASSFILTER
DISPOSITIF ET PROCEDE D'ETALONNAGE A MECANISME VERS L'AVANT/VERS L'ARRIERE POUR UN FILTRE PASSE-BANDE

(43) Date of publication of application: 16.07.2008
(73) Proprietor: NXP B.V., 5656 AG Eindhoven (NL)
(72) Inventor: TOURRET, Jean-Robert, F-75008 Paris (FR)
(74) Representative: Schouten, Marcus Maria
(86) International application number: PCT/IB2005/053515
(87) International publication number: WO 2007/049099

(56) References cited:
- US-A- 4 843 636
- US-A- 5 280 638
- US-A- 5 822 687
- US-A1- 2003 176 174

## Description

### Field of the invention

The present invention relates to the domain of radio frequency (RF) signal filtering, and more precisely to the calibration of RF band-pass filters in RF communication receiver equipment.

### Background of the invention

As it is known by one skilled in the art, a RF communication receiver generally comprises a RF front-end filter to suppress the power contained in the unwanted channels which are adjacent to a transmission channel. Such a suppression allows the RF communication receiver to meet the linearity requirements, mandatory for channel selectivity, and to reduce the power consumption of the communication equipment in which the RF communication receiver is installed.

In RF communication equipment, and especially terrestrial equipments, which have to cope with a large input frequency range, typically from 50 MHz to 1 GHz, the filter must be a tracked band-pass filter which needs to be accurately tuned to the desired frequency.

Most of the tuner devices use a super-heterodyne architecture according to which the RF signal (F_{RF}) is down-converted to an intermediate frequency (F_{IF}), and a local oscillator signal (F_{LO}) for tracking F_{RF} - F_{IF}. The RF filter should have its maximum at F_{IF} + F_{LO}. The local oscillator is generally a Voltage Controlled Oscillator (VCO) controlled by a PLL ("Phase Locked Loop") and tuned by an external varactor. In order to track the RF frequency F_{RF}, the RF filter must have a varactor which is of the same type as the VCO and the voltage applied to the VCO varactor must be applied to the RF filter varactor.

The use of the same varactors for the RF filter and the VCO allows a very accurate tracking over the whole frequency range. But, an external tank circuit is required for the VCO, which is not compatible with the recent architectures of the local oscillators comprising internal varactors.

It has been also proposed to up-convert the RF signal to a higher frequency than the maximum RF frequency F_{RF}, then to saw-filter it with an accurate external component and down-convert it in baseband. This avoids the tracking of a filter, as the filtering is done at a fixed frequency. But this induces huge noise figure (NF) / linearity performances on the up-mixing part, and this is relatively expensive.

In the patent document US 2003/0176174 it has also been proposed to feed the filter with a series of test signals with different frequencies and to measure the output powers corresponding to each test signal in baseband and after RF mixing to determine which one has produced the highest output power in baseband. This process is not really accurate and does not allow to make a decision in real time.

US 5,280,638 discloses a variable frequency RF passband filter that is aligned or calibrated to maximise the sensitivity of a radio receiver using reference frequencies obtained using a fixed frequency oscillator, in which a tuning voltage is selected that corresponds with the maximum signal strength value during stepping over a range of tuning voltages.

### Summary of the invention

So, the object of this invention is to overcome the above mentioned drawbacks at least partly.

For this purpose, the invention provides a process for a radio frequency band- pass filter as defined by claim 1.

The calibration process according to the invention may include additional characteristics considered separately or combined, and notably:
- the first way may correspond to successive increasing control voltage values and the second way to successive decreasing control voltage values, or conversely, the first way may correspond to successive decreasing control voltage values and the second way to successive increasing control voltage values,
- during the second step one may determine the beginning of the decreasing of the output power value by detecting an inversion of the sign of a variable representative of an output power variation, then one stores the first decreasing output power value which corresponds to this sign inversion and the corresponding control voltage,
   - during the second step one may determine the variable after each measurement by subtracting the previous measured output power value from the current measured output power value in order to stop applying a new voltage when the result of a subtraction is lower than zero (thus indicating the sign inversion), then one may store the current measured output power value and the corresponding control voltage,
- during the third step one may stop applying a control voltage when the corresponding output power value applied last is equal to or lower than the stored first decreasing output power value,
- during the third step one may apply successive control voltages to the filter by starting from the stored control voltage.

The invention also provides a calibration device for a radio frequency band- pass filter as defined by claim 8.

The calibration device according to the invention may include additional characteristics considered separately or combined, and notably:
- the first way may correspond to successive increasing control voltage values and the second way to successive decreasing control voltage values, or conversely the first way may correspond to successive decreasing control voltage values and the second way to successive increasing control voltage values,
- its control means may be arranged to determine the beginning of the decrease of the output power value (and therefore the first decreasing output power value) by detecting an inversion of the sign of a variable representative of an output power variation, then to store the first decreasing output power value which corresponds to this sign inversion and the corresponding control voltage,
   - its control means maybe arranged to determine the variable after each measure (carried out during the detection of the sign inversion) by subtracting the previous measured output power value from the current measured output power value to order the power supply means to stop applying a new voltage when the result of a subtraction is lower than zero (thus indicating the sign inversion), then to store the current output power value and the corresponding control voltage,
- its control means may be arranged to decide to order the power supply means to stop applying a control voltage to the filter means when the corresponding output power value applied last is equal to or lower than the stored first decreasing output power value,
- for the (last) detection of the decreasing value, its control means may be arranged to order the power supply means to apply to the filter means successive control voltages by starting from the stored control voltage,
- its control means may be arranged to store the first decreasing output power value in a first analog memory,
- its control means may be arranged to store the control voltage (corresponding to the first decreasing output power value) in a second digital memory.

The invention also provides a communication receiver comprising:
i) a radio frequency band-pass filter comprising a filter means for filtering a frequency band (depending on the value of an applied control voltage), and a controllable power supply means for applying a control voltage to the filter means, and
ii) a calibration device such as the one above introduced and coupled to the filter means and power supply means.

The invention also provides communication equipment comprising a communication receiver such as the one introduced above.

### Brief description of the drawings

Other features and advantages of the invention will become apparent on examining the detailed specifications hereafter and the appended drawings, wherein:
- Fig. schematically illustrates communication equipment provided with a communication receiver comprising a calibration device according to the invention,
- Figs. 2A and 2B schematically illustrate diagrams respectively illustrating the second and third steps of the calibration process according to the invention, and
- Fig.3 illustrates an algorithm defining an example of a calibration process according to the invention.

The appended drawings may not only serve to complete the invention, but also contribute to its definition, if need be.

### Description of preferred embodiments

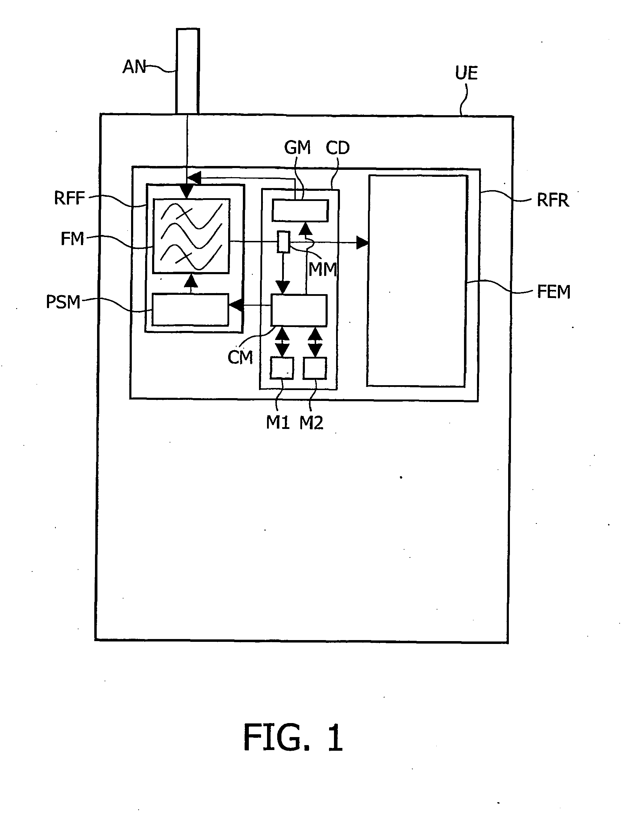

As illustrated in Fig.1 the invention provides a calibration device CD dedicated to a radio frequency (RF) communication receiver RFR which may be implanted in RF communication equipment UE.

In the following description it will be considered that the RF communication equipment UE is a mobile telephone, for instance a GSM/GPRS or UMTS mobile telephone. But it is important to notice that the invention is not limited to this type of RF communication equipment.

Indeed the invention may be applied to any RF communication equipment, mobile (or not) and notably to a personal digital assistant (PDA) or a laptop comprising a communication module adapted to establish radio communications, or else in radios (AM, FM), or else in television (TV) tuners or TV sets connected to set-top-boxes (STBs).

As illustrated in Fig.1, a RF communication receiver RFR comprises a RF front-end module FEM fed by a RF front-end filter RFF, which is connected to an access of an antenna AN, for suppressing the power contained in the unwanted channels which are adjacent to the transmission channel. It is recalled that a FEM down-converts a desired signal to baseband and generally comprises a low noise amplifier (LNA), a variable gain amplifier (VGA) and a mixer, whose respective positions in a processing chain depend on the chosen architecture and on the broadcasting specifications.

It is also recalled that the transmission channel is a channel allowing the data transmission between distant communication transmitter and receiver at a radio frequency belonging to a chosen narrow working band frequency.

To carry out such a suppression the filter RFF comprises a filter module FM which needs to be accurately calibrated around the central frequency of the working band frequency of its communication receiver RFR. The central frequency of the filter RFF depends on the voltage applied to the terminals of its filter module FM.

The filter RFF also comprises a controllable power supply module PSM in charge of applying a chosen control voltage to the filter module in order to filter the received RF signals in the chosen working band frequency before they reach the RF front-end module FEM.

For instance the controllable power supply module PSM comprises a varactor arranged to define discrete voltage values Vi (I = 0 to n) associated to discrete filter working frequencies Fi included in the interval [F0, Fn], where F0 and Fn are respectively the minimal and maximal filter working frequencies. In other words, to each voltage Vi applied by the controllable power supply module PSM corresponds one filtering frequency Fi of the filter module FM.

Instead of a varactor, the controllable power supply module PSM may comprise a bank of switched capacitors. In this case, each voltage Vi is defined by a capacity value Ci. In another variant, the controllable power supply module PSM may comprise a bank of switched varactors, made of a combination of varactors mounted in series with switches to expand their tuning capabilities.

The filter RFF may be based on the UHF-VHF 1316 tuner of PHILIPS, for instance.

To define accurately the filter working frequency Fi, the voltage Vi must be accurately chosen by means of a calibration process.

This calibration process may be implemented by means of the example of the calibration device CD illustrated in Fig.1 and which will now be described.

The illustrated calibration device CD comprises a generator GM which is arranged to feed the filter module FM with a test signal of a chosen input power and a chosen frequency FLO under the control of a control module CM. It also comprises a power measurement module MM arranged to measure the output power value Pₒᵤₜ of the test signal at the output of the filter module FM.

The control module CM is coupled to the controllable power supply module PSM of the RF filter RFF in order to provide it with instructions defining control voltages Vi to be applied to the filter module FM.

The aim of the calibration device CD is to determine the control voltage VLO which permits the filter module FM to output the test signal having the chosen frequency FLO with the highest power.

For this purpose, in a first main step the control module CM orders the generator GM to feed the filter module with the chosen frequency FLO (and the chosen input power).

Then in a second main step the control module CM first orders the controllable power supply module PSM to apply to the filter module FM successive control voltages, whose values are varying in a first way, as long as the output power value Pₒᵤₜ of the test signal (which are measured by the measurement module MM) increases, then reaches a maximum value and then begins to decrease, and secondly stores the (first) decreasing output power value P_{Φ1} and the corresponding control voltage Vup respectively in first M1 and second M2 memories.

For this purpose, the control module CM may, for instance, determine the beginning of the decreasing of the output power value Pₒᵤₜ of the test signal (and then the first decreasing output power value) by detecting an inversion of the sign of a variables representing an output power variation from the output power values Pₒᵤₜ. Then it stores the first decreasing output power value P_{Φ1} which corresponds to this sign inversion and the corresponding control voltage Vup.

Then in a third main step the control module CM firstly again orders the controllable power supply module PSM to apply to the filter module FM successive control voltages whose values are varying in a second way opposite to the first way, as long as the output power value increases, reaches the maximum value and then begins to decrease to a last value, then secondly determines a control voltage VLO which corresponds to the maximum of the filter output power at the chosen frequency FLO of the test signal from the stored control voltage Vup and the control voltage Vdo applied last and corresponding to the last output power value.

For instance, the control value Vdo applied last corresponds to the (last) output power value equal to or lower than the stored first decreasing output power value P_{Φ1}.

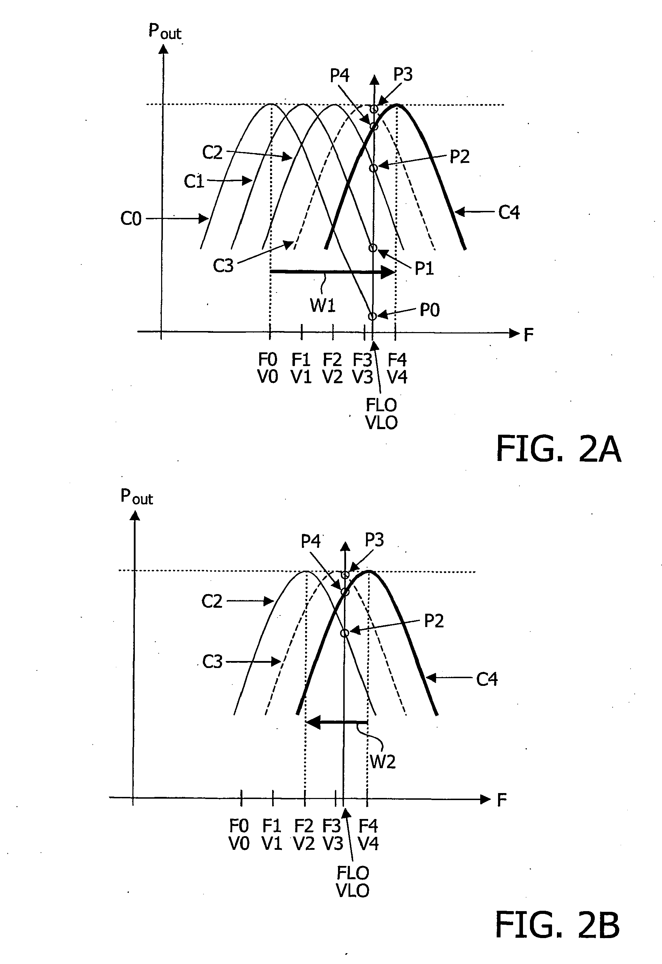

Preferably, the first way (arrow W1 in Fig;2A) corresponds to successive increasing control voltage values Vi and the second way (arrow W2 in Fig.2B) to successive decreasing control voltage values Vi. But, this is not mandatory. It is effectively possible that the first way corresponds to successive decreasing control voltage values and the second way to successive increasing control voltage values.

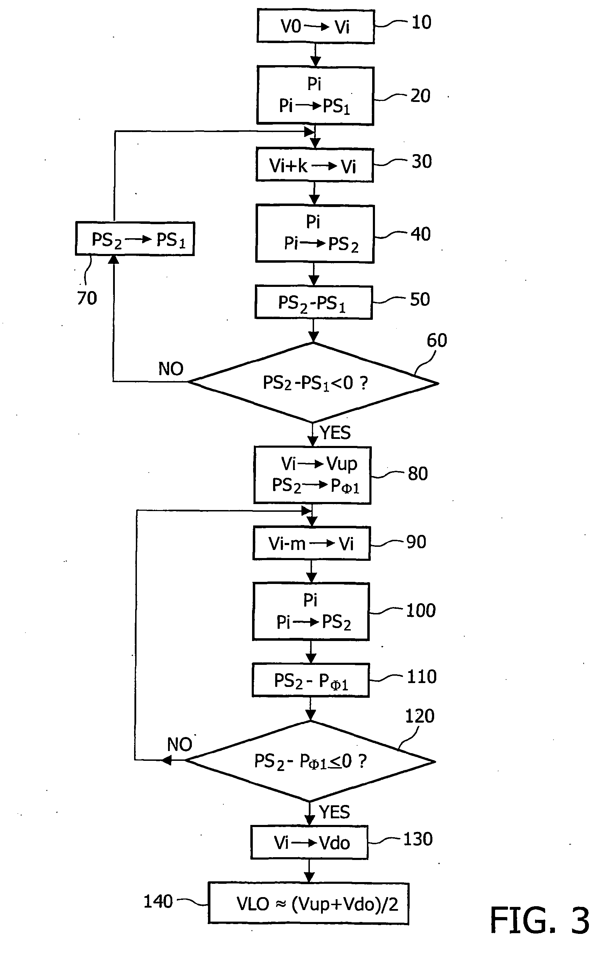

The calibration process implemented by the calibration device CD will now be described in more detail with reference to the example of diagrams illustrated in Figs. 2A and 2B and to the example of the algorithm illustrated in Fig.3.

One will focus hereafter on the example of implementation of the calibration process in which the first decreasing output power value is determined by means of the detection of the sign inversion. But, as mentioned above, the invention is not limited to this implementation. It is effectively possible to analyze the output power values Pₒᵤₜ during the second main step in order to detect the one that reaches a maximum and then the next one that begins to decrease.

In the non-limiting illustrated example one considers that the first way (W1) corresponds to successive increasing control voltage values Vi and the second way (W2) to successive decreasing control voltage values Vi.

The first main step only comprises a first part of step 10 in which the control module CM orders the generator GM to feed the filter RFF with the test signal (FLO).

The second main step starts with a second part of step 10 in which the control module CM orders the controllable power supply module PSM to apply a first control voltage V0 (i = 0) to the filter module FM.

The calibration device CD may comprise a look-up table in which are stored each first control voltage value V0 to be applied in accordance with each test signal frequency FLO of the filter module FM concerted.

In a step 20 the measurement module MM measures the output power P0 (i = 0) of the test signal and the control module CM stores this output power value P0 in a first buffer (not illustrated) where it is called PS₁.

In a step 30 the control module CM orders the controllable power supply module PSM to apply a second control voltage Vi + k, higher than the previous one (V0), to the filter module FM. For instance k = 1 (and therefore the second control voltage is V1), but this is not mandatory. k is effectively an increment whose value may be chosen (or programmable).

In a step 40 the measurement module MM measures the output power P1 (i = 1, for instance) of the test signal and the control module CM stores this output power value P1 in a second buffer (not illustrated) where it is called PS₂.

In a step 50 the control module CM subtracts the (previous) output power value PS₁ stored in the first buffer and which is equal to P0 from the (current) output power value PS₂ stored in the second buffer and which is equal to P1.

In a step 60 the control module CM checks whether the result of the subtraction (variable Δ) is lower than zero (PS₂ - PS₁ < 0).

If PS₂ is lower than PS1, then the control module CM goes to step 80.

If PS₂ is greater than PS₁, then in a step 70 the control module CM stores PS₂ in the first buffer in order for the current value P1 to replace P0 as PS₁. Then the control module CM goes to step 30 in order for the controllable power supply module PSM to apply a new (third) control voltage Vi + k (V2), higher than the previous one (V1).

In the diagram of Fig.2A the output power P1 (PS₂), which is materialized by the intersection between the filter gain curve C1 at the frequency F1 and the vertical line at the test signal frequency FLO, is greater than the output power P0 (PS₁), which is materialized by the intersection between the filter gain curve C0 at the frequency F0. Therefore the control module CM goes to step 30 to order the controllable power supply module PSM to apply a third, control voltage Vi + k (V2), higher than the previous one (V1). The control module CM executes steps 30 to 50. In step 60 the control module CM detects that PS₂ (P2) is greater than PS₁ (P1). Thenin a step 70 it stores PS₂ in the first buffer in order for the current value P2 to replace P1 as PS₁. The output power P2 (PS₂), which is materialized by the intersection between the filter gain curve C2 at the frequency F2, and the vertical line at the test signal frequency FLO, is effectively greater than the output power P1 (PS₁).

Then the control module CM goes back to step 30 to order the controllable power supply module PSM to apply a new (fourth) control voltage Vi + k (V3), higher than the previous one (V2). The control module CM again executes steps 30 to 50. In step 60 the control module CM detects that PS₂ (P3) is greater than PS₁ (P2), then in a step 70 it stores PS₂ in the first buffer in order for the current value P3 to replace P2 as PS₁. The output power P3 (PS₂), which is materialized by the intersection between the filter gain curve C3 at the frequency F3, and the vertical line at the test signal frequency FLO, is effectively greater than the output power P2 (PS₁).

Then the control module CM goes back to step 30 to order the controllable power supply module PSM to apply a new (fifth) control voltage Vi + k (V4) (corresponding to gain curve C4 at the frequency F4), higher than the previous one (V3). The control module CM again executes steps 30 to 50. In step 60 the control module CM detects that PS₂ (P4) is now smaller than PS₁ (P3).

The sign of the subtraction result (Δ = PS₂ - PS₁) now being negative, whereas it has been positive up to now, it means that a sign inversion has occurred and therefore that the optimal value of the control voltage VLO, corresponding to the test signal frequency FLO, has been crossed (or passed through). So, the control module CM must go back to find this optimal value of the control voltage VLO.

Before going back the control module CM stores PS₂, in a step 80, in the first memory M1, where it is now named P_{Φ1}, and the corresponding control voltage V4 (i = 4) in the second memory M2, where it is named Vup.

Preferably the first memory M1 is arranged to store the output power P_{Φ1} in analog form, while the memory M2 is arranged to store the corresponding control voltage Vup in digital form.

Step 80 terminates the second main step.

The third main step starts with step 90 in which the control module CM orders the controllable power supply module PSM to apply a new (sixth) control voltage Vi - m, preferably smaller than the previous one (V4), to the filter module FM. For instance m = 1 (and therefore the new (sixth) control voltage is V3), but this is not mandatory. m is effectively a decrement whose value may be chosen in dependence on the calibration accuracy. Moreover, m is not necessarily equal to k.

As mentioned above, it is preferable to start the third main step from the last control voltage (V4) having induced the sign inversion in the second main step, because the greater control voltage would induce a lower output power. Moreover, it is unnecessary to apply again the last control voltage (V4) of the second main step because the corresponding output power is supposed to be constant.

In a step 100 the measurement module MM measures the output power P3 (i = 3, for instance) of the test signal and the control module CM stores this output power value P3 in the second buffer where it is named PS₂.

In a step 110 the control module CM subtracts the output power value P_{Φ1}, stored in the first memory M1 and which is equal to P4 in this example, from the (current) output power value PS₂, stored in the second buffer and which is equal to P3 in this example.

In a step 120 the control module CM checks whether the result of the subtraction is lower than or equal to zero (PS₂ - P_{Φ1} ≤ 0).

If PS₂ is lower than or equal to P_{Φ1}, then the control module CM goes to step 130.

If PS₂ is greater than PS₁, then the control module CM goes back to step 90 to order the controllable power supply module PSM to apply a new control voltage Vi - m (V2), lower than the previous one (V3).

In the diagram of Fig.2B the output power P3 (PS₂), which is materialized by the intersection between the filter gain curve C3 at the frequency F3, and the vertical line at the test signal frequency FLO, is greater than the stored (first) output power P_{Φ1}, (equal to V4 in this example). Therefore, the control module CM goes to step 90 to order the controllable power supply module PSM to apply a seventh control voltage Vi - m (V2), lower than the previous one (V3). The control module CM executes steps 100 to 110. In step 120 the control module CM detects that PS₂ (P2) is now equal to or smaller than P_{Φ1} (P4), then in a step 130 it stores V2, which corresponds to PS₂, in a third buffer where it is called Vdo.

The sign of the subtraction result (PS₂ - P_{Φ1}) now being negative (or zero), whereas it has been positive up to now, it means that the optimal value of the control voltage VLO, corresponding to the test signal frequency FLO, has been crossed again (or passed through).

The control module CM having now at its disposal first Vdo and second Vup control voltage values which are just lower than and just greater than the optimal value VLO respectively, it can determine this optimal value VLO.

So, in a step 140 the control module CM determines the optimal value VLO by adding the control voltage Vup, which is stored in the second memory M2, to the control voltage Vdo applied last, which is stored in the third buffer, and then by dividing the result of this addition by 2, for instance. In other words the control module CM calculates for instance VLO ≈ (Vup + Vdo)/2.

In a variant, it is also possible to store in a look-up table all the control values that may be applied by the controllable power supply module PSM to the filter module FM in order to determine the control voltage value VLO which is found between Vup and Vdo.

In another variant, it is also possible to determine very precisely the maximum value VLO during the third main step by reducing the step between two consecutive control voltages Vi and by analyzing each output power value Pₒᵤₜ in order to detect the one that reaches a maximum and then the next one that begins to decrease.

The step 140 ends the third main step of the calibration process according to the invention.

Afterwards the optimal control voltage value VLO can be applied by the controllable power supply module PSM to the filter module FM in order to filter the received RF signals having approximately the chosen frequency FLO corresponding to VLO.

The calibration device CD may be a programmable integrated circuit realized in CMOS technology or in any technology used in chip manufacture.

To increase the precision of the optimal control voltage value VLO it is possible to implement an additional step based on a phase detection by means of a PLL ("Phase Locked Loop").

For instance one feeds the filter module FM with an input signal S1 having a chosen phase, and one determines the signal S2 at the output of the filter module FM. Then signals S1 and S2 are separately amplified to become signals Sa1 and Sa2 respectively, which are then fed to a phase detector provided for controlling (increasing or decreasing) the voltage applied to a varicap depending on the sign of the phase shift between Sa1 and Sa2. This phase shift may be controlled by means of a forward/backward mechanism such as the one described above, but applied to the voltage of the varicap.

The invention is not limited to the embodiments of calibration device, communication receiver, communication equipment and calibration process described above, by way of example only, but it encompasses all alternative embodiments which may be considered by one skilled in the art to be within the scope of the following claims.

## Claims

1. Calibration process for a radio frequency band-pass filter (RFF) arranged to filter a frequency band in dependence on the value of an applied control voltage, the process comprising a first step in which one feeds said filter (RFF) with a test signal of a chosen input power and a chosen frequency (FLO), a second step in which one applies to said filter (RFF) successive control voltages (Vi) whose values are varying in a first way and measures the corresponding output power values (Pₒᵤₜ) of said test signal at the output of said filter (RFF) as long as the output power value increases, reaches a maximum value and then begins to decrease, then one stores the first decreasing output power value (P_{Φ1}) and the corresponding control voltage (Vup), and a third step in which one applies to said filter (RFF) successive control voltages (Vi) whose values are varying in a second way opposite to said first way, and measures the corresponding test signal output power values (Pₒᵤₜ) as long as the output power value increases, reaches said maximum value and then begins to decrease to a last output power value, then one determines a control voltage (VLO), corresponding to said maximum of the filter output power at the chosen frequency (FLO) of said test signal from the stored control voltage (Vup) and the control voltage (Vdo) applied last and corresponding to said last output power value, **characterized in that** during said third step the control voltage (VLO), corresponding to the maximum of the filter output power at the chosen frequency (FLO) of the test signal, is determined by adding the stored control voltage (Vup) to the control voltage (Vdo) applied last and by dividing the result of this addition by 2.

2. Calibration process according to claim 1, **characterized in that** said first way corresponds to successive increasing control voltage values (Vi) and said second way corresponds to successive decreasing control voltage values (Vi).

3. Calibration process according to claim 1, **characterized in that** said first way corresponds to successive decreasing control voltage values (Vi) and said second way corresponds to successive increasing control voltage values (Vi).

4. Calibration process according to any one of claims 1 to 3, **characterized in that** during the second step one determines the beginning of the decreasing of the output power value by detecting an inversion of the sign of a variable representative of an output power variation, then one stores the first decreasing output power value (P_{Φ1}) which corresponds to this sign inversion and the corresponding control voltage (Vup).

5. Calibration process according to claim 4, **characterized in that** during the second step one determines said variable after each measurement by subtracting the previous measured output power value (PS₁) from the current output power value (PS₂) in order to stop applying a new voltage when the result of a subtraction is lower than zero, thus indicating said sign inversion, then one stores the current measured output power value (P_{Φ1}) and the corresponding control voltage (Vup).

6. Calibration process according to any one of claims 1 to 5, **characterized in that** during said third step one may stop applying a control voltage when the corresponding output power value applied last is equal to or lower than the stored first decreasing output power value (P_{Φ1}).

7. Calibration process according to any one of claims 1 to 6, **characterized in that** during said third step one applies successive control voltages (Vi) to said filter (RFF) by starting from the stored control voltage (Vup).

8. Calibration device (CD), for a radio frequency band-pass filter (RFF) comprising a filter means (FM) for filtering a frequency band, depending on the value of an applied control voltage (Vi), and controllable power supply means (PSM) for applying a control voltage to said filter means (FM), the device comprising:
i) a generator (GM) arranged to feed said filter means (FM) with a test signal of a chosen input power and a chosen frequency (FLO),
ii) a measuring means (MM) arranged to measure the output power values (Vi) of said test signal at the output of said filter means (FM), and
iii) a control means (CM) arranged:
a) to order said power supply means (PSM) to apply to said filter means (FM) successive control voltages (Vi) whose values are varying in a first way, as long as the output power value increases, reaches a maximum value and then begins to decrease, then
b) to store the first decreasing output power value (P1) and the corresponding control voltage (Vup), then
c) to order said power supply means (PSM) to apply to said filter means (FM) successive control voltages (Vi) whose values are varying in a second way opposite to said first way, as long as the output power value increases, reaches said maximum value and then begins to decrease to a last output power value, and then
d) to determine a control voltage (VLO) corresponding to a maximum of the filter output power at the chosen frequency (FLO) of said test signal from the stored control voltage (Vup) and a control voltage (Vdo) applied last and corresponding to said last output power value,
**characterized in that** said control means (CM) are arranged to determine said control voltage (VLO), corresponding to the maximum of the filter output power at the chosen frequency (FLO) of the test signal, by adding the stored control voltage (Vup) to the control voltage (Vdo) applied last and by dividing the result of this addition by 2.

9. Calibration device according to claim 8, **characterized in that** said first way corresponds to successive increasing control voltage values (Vi) and said second way corresponds to successive decreasing control voltage values (Vi).

10. Calibration device according to claim 8, **characterized in that** said first way corresponds to successive decreasing control voltage values (Vi) and said second way corresponds to successive increasing control voltage values (Vi).

11. Calibration device according to any one of claims 8 to 10, **characterized in that** said control means (CM) are arranged to determine a beginning of the decrease of the output power value by detecting an inversion of the sign of a variable representative of an output power variation, then to store the first decreasing output power value (P_{Φ1}) which corresponds to this sign inversion and the corresponding control voltage (Vup).

12. Calibration device according to claim 11, **characterized in that** said control means (CM) are arranged to determine said variable after each measure by subtracting the previous output power value (PS₁) from the current output power value (PS₂) to order said power supply means (PSM) to stop applying a new voltage when the result of a subtraction is lower than zero, thus indicating said sign inversion, then to store the current output power value (P_{Φ1}) and the corresponding control voltage (Vup).

13. Calibration device according to any one of claims 8 to 12, **characterized in that** said control means (CM) are arranged to decide to order said power supply means (PSM) to stop applying a control voltage to said filter means (FM) when the output power value applied last and corresponding to the control voltage applied last is equal to or lower than the stored first decreasing output power value (P_{Φ1}).

14. Calibration device according to any one of claims 8 to 13, **characterized in that** said control means (CM) is arranged, for the last detection of the decreasing value, to order said power supply means (PS) to apply to said filter means (FM) successive control voltages by starting from the stored control voltage (Vup).

15. Calibration device according to any one of claims 8 to 14, **characterized in that** it comprises a first analog memory (MI) in which said control means (CM) is arranged to store said first decreasing output power value (P_{Φ1}) in analog form.

16. Calibration device according to any one of claims 8 to 15, **characterized in that** it comprises a second digital memory (M2) in which said control means (CM) are arranged to store said control voltage (Vup) corresponding to the first decreasing output power value (P) in digital form.

17. Communication receiver (RFR) comprising a radio frequency band-pass filter (RFF) comprising a filter means (FM) for filtering a frequency band, depending on the value of an applied control voltage (Vi), and a controllable power supply means (PSM) for applying a control voltage (Vi) to said filter means (FM), **characterized in that** it comprises a calibration device (CD) according to one of claims 8 to 16, coupled to said filter means (FM) and to said power supply means (PSM).

18. Communication equipment (UE), **characterized in that** it comprises a communication receiver (RFR) according to claim 17.

## Patentansprüche

1. Kalibrierungsprozess für ein Hochfrequenz-Bandpassfilter (RFF), das so ausgeführt ist, dass es ein Frequenzband in Abhängigkeit vom Wert einer angelegten Steuerspannung filtert, wobei der Prozess einen ersten Schritt, in dem dem Filter (RFF) ein Testsignal mit einer ausgewählten Eingangsleistung und einer ausgewählten Frequenz (FLO) zugeführt wird, einen zweiten Schritt, in dem an das Filter (RFF) schrittweise Steuerspannungen (Vi) angelegt werden, deren Werte in einer ersten Weise variieren, und die entsprechenden Ausgangsleistungswerte (Pₒᵤₜ) des Testsignals am Ausgang des Filters (RFF) gemessen werden, solange der Ausgangsleistungswert ansteigt, einen Maximalwert erreicht und dann zu sinken beginnt, woraufhin der erste sinkende Ausgangsleistungswert (P_{Φ1}) und die entsprechende Steuerspannung (Vup) gespeichert werden, und einen dritten Schritt umfasst, in dem an das Filter (RFF) schrittweise Steuerspannungen (Vi) angelegt werden, deren Werte in einer zweiten Weise entgegengesetzt zur ersten Weise variieren, und die entsprechenden Testsignalausgangsleistungswerte (Pₒᵤₜ) gemessen werden, solange der Ausgangsleistungswert ansteigt, einen Maximalwert erreicht und dann auf einen letzten Ausgangsleistungswert zu sinken beginnt, woraufhin eine Steuerspannung (VLO) entsprechend dem Maximum der Filterausgangsleistung bei der ausgewählten Frequenz (FLO) des Testsignals anhand der gespeicherten Steuerspannung (Vup) und der Steuerspannung (Vdo), die zuletzt angelegt wurde und dem letzten Ausgangsleistungswert entspricht, bestimmt wird, **dadurch gekennzeichnet, dass** während des dritten Schritts die Steuerspannung (VLO), die dem Maximum der Filterausgangsleistung der ausgewählten Frequenz (FLO) des Testsignals entspricht, bestimmt wird, indem die gespeicherten Steuerspannung (Vup) zu der Steuerspannung (Vdo), die zuletzt angelegt worden ist, addiert wird und das Ergebnisses dieser Addition durch zwei dividiert wird.

2. Kalibrierungsprozess nach Anspruch 1, **dadurch gekennzeichnet, dass** die erste Weise dem schrittweisen Erhöhen der Steuerspannungswerte (Vi) entspricht und die zweite Weise dem schrittweisen Senken der Steuerspannungswerte (Vi) entspricht.

3. Kalibrierungsprozess nach Anspruch 1, **dadurch gekennzeichnet, dass** die erste Weise dem schrittweisen Senken der Steuerspannungswerte (Vi) entspricht und die zweite Weise dem schrittweisen Erhöhen der Steuerspannungswerte (Vi) entspricht.

4. Kalibrierungsprozess nach irgendeinem der Ansprüche 1 bis 3, **dadurch gekennzeichnet, dass** während des zweiten Schritts der Beginn der Absenkung des Ausgangsleitungswertes bestimmt wird, indem eine Umkehrung des Vorzeichens einer Variablen, die eine Ausgangsleistungsvariation repräsentiert, erfasst wird, woraufhin der erst absinkende Ausgangsleistungswert (P_{Φ1}), der dieser Vorzeichenumkehrung entspricht, und die entsprechende Steuerspannung (Vup) gespeichert werden.

5. Kalibrierungsprozess nach Anspruch 4, **dadurch gekennzeichnet, dass** während des zweiten Schritts die Variable nach jeder Messung bestimmt wird, indem der vorangehend gemessene Ausgangsleistungswert (PS₁) vom aktuellen Ausgangsleistungswert (PS₂) subtrahiert wird, um das Anlegen einer neuen Spannung zu stoppen, wenn das Ergebnis einer Subtraktion kleiner als 0 ist, was die Vorzeichenumkehrung anzeigt, woraufhin der aktuell gemessene Ausgangsleistungswert (P_{Φ1}) und die entsprechende Steuerspannung (Vup) gespeichert werden.

6. Kalibrierungsprozess nach irgendeinem der Ansprüche 1 bis 5, **dadurch gekennzeichnet, dass** während des dritten Schritts das Anlegen einer Steuerspannung gestoppt werden kann, wenn der entsprechende Ausgangsleistungswert, der zuletzt angelegt worden ist, gleich oder kleiner als der gespeicherte erste absinkende Ausgangsleistungswert (P_{Φ1}) ist.

7. Kalibrierungsprozess nach irgendeinem der Ansprüche 1 bis 6, **dadurch gekennzeichnet, dass** während des dritten Schritts schrittweise Steuerspannungen (Vi) an das Filter (RFF) angelegt werden, beginnend mit der gespeicherten Steuerspannung (Vup).

8. Kalibrierungsvorrichtung (CD) für ein Hochfrequenz-Bandpassfilter (RFF), das ein Filtermittel (FM) zum Filtern eines Frequenzbandes in Abhängigkeit vom Wert einer angelegten Steuerspannung (Vi) und steuerbare Energiezuführungsmittel (PSM) zum Anlegen einer Steuerspannung an das Filtermittel (FM) umfasst, wobei die Vorrichtung umfasst:
i) einen Generator (GM), der so ausgeführt ist, dass er dem Filtermittel (FM) ein Testsignal einer ausgewählten Eingangsleistung und einer ausgewählten Frequenz (FLO) zuführt,
ii) ein Messmittel (MM), das so ausgeführt ist, dass es die Ausgangsleistungswerte (Vi) des Testsignals am Ausgang des Filtermittels (FM) misst, und
iii) ein Steuermittel (CM), das so ausgeführt ist, dass es:
a) das Energiezuführungsmittel (PSM) anweist, an das Filtermittel (FM) Steuerspannungen (Vi) anzulegen, deren Werte in einer ersten Weise variieren, solange der Ausgangsleistungswert ansteigt, ein Maximum erreicht und anschließend zu sinken beginnt, anschließend
b) den ersten sinkenden Ausgangsleistungswert (P1) und die entsprechende Steuerspannung (Vup) speichert, anschließend
c) das Energiezuführungsmittel (PSM) anweist, an das Filtermittel (FM) schrittweise Steuerspannungen (Vi) anzulegen, deren Werte in einer zweiten Weise entgegengesetzt zur ersten Weise variieren, solange der Ausgangsleistungswert ansteigt, den Maximalwert erreicht und anschließend auf einen letzten Ausgangsleistungswert abzusinken beginnt, und anschließend
d) eine Steuerspannung (VLO), die einem Maximum der Filterausgangsleistung bei der ausgewählten Frequenz (VLO) des Testsignals entspricht, anhand der gespeicherten Steuerspannung (Vup) und einer Steuerspannung (Vdo), die zuletzt angelegt worden ist und dem letzten Ausgangsleistungswert entspricht, bestimmt,
**dadurch gekennzeichnet, dass** das Steuermittel (CM) so ausgeführt ist, dass es die Steuerspannung (VLO), die dem Maximum der Filterausgansleistung bei der ausgewählten Frequenz (FLO) des Testsignals entspricht, bestimmt, indem es die gespeicherte Steuerspannung (Vup) zu der zuletzt angelegten Steuerspannung (Vdo) addiert und das Ergebnis dieser Addition durch 2 dividiert.

9. Kalibrierungsvorrichtung nach Anspruch 8, **dadurch gekennzeichnet, dass** die erste Weise dem schrittweisen Erhöhen der Steuerspannungswerte (Vi) entspricht und die zweite Weise dem schrittweisen Senken der Steuerspannungswerte (Vi) entspricht.

10. Kalibrierungsvorrichtung nach Anspruch 8, **dadurch gekennzeichnet, dass** die erste Weise dem schrittweisen Senken der Steuerspannungswerte (Vi) entspricht und die zweite Weise dem schrittweisen Erhöhen der Steuerspannungswerte (Vi) entspricht.

11. Kalibrierungsvorrichtung nach irgendeinem der Ansprüche 8 bis 10, **dadurch gekennzeichnet, dass** die Steuermittel (CM) so ausgeführt sind, dass sie einen Beginn der Absenkung des Ausgangsleistungswertes bestimmen, indem sie eine Umkehrung des Vorzeichens einer Variable, die eine Ausgangsleistungsvariation repräsentiert, erfassen, und dann den ersten absinkenden Ausgangsleistungswert (P_{Φ1}), der dieser Vorzeichen Umkehrung entspricht, und die entsprechende Steuerspannung (Vup) speichern.

12. Kalibrierungsvorrichtung nach Anspruch 11, **dadurch gekennzeichnet, dass** die Steuermittel (CM) so ausgeführt sind, dass sie die Variable nach jeder Messung bestimmen, indem sie den vorangehenden Ausgangsleistungswert (PS₁) vom aktuellen Ausgansleistungswert (PS₂) subrahieren, um das Energiezuführungsmittel (PSM) anzuweisen, das Anlegen einer neuen Spannung zu stoppen, wenn das Ergebnis einer Subtraktion kleiner als 0 ist, was die Vorzeichenumkehrung anzeigt, und anschließend den aktuellen Ausgangsleistungswert (P_{Φ1}) und die entsprechende Steuerspannung (Vup) speichern.

13. Kalibrierungsvorrichtung nach irgendeinem der Ansprüche 8 bis 12, **dadurch gekennzeichnet, dass** die Steuermittel (CM) so ausgeführt sind, dass sie entscheiden, das Energiezuführungsmittel (PSM) anzuweisen, das Anlegen einer Steuerspannung an das Filtermittel (FM) zu stoppen, wenn der Ausgangsleistungswert, der zuletzt angelegt worden ist und der zuletzt angelegten Steuerspannung entspricht, gleich oder kleiner als der gespeicherte erste absinkende Ausgangsleistungswert (P_{Φ1}) ist.

14. Kalibrierungsvorrichtung nach irgendeinem der Ansprüche 8 bis 13, **dadurch gekennzeichnet, dass** das Steuermittel so ausgeführt ist, dass es für die letzte Erfassung des absinkenden Wertes das Energiezuführungsmittel (PS) anweist, an das Filtermittel (FM) schrittweise Steuerspannungen anzulegen, beginnend mit der gespeicherten Steuerspannung (Vup).

15. Kalibrierungsvorrichtung nach irgendeinem der Ansprüche 8 bis 14, **dadurch gekennzeichnet, dass** sie einen ersten analogen Speicher (M1) umfasst, in dem das Steuermittel (CM) so ausgeführt ist, dass es den ersten absinkenden Ausgangsleistungswert (P_{Φ1}) in analoger Form speichert.

16. Kalibrierungsvorrichtung nach irgendeinem der Ansprüche 8 bis 15, **dadurch gekennzeichnet, dass** sie einen zweiten digitalen Speicher (M2) umfasst, in dem die Steuermittel (CM) so ausgeführt sind, dass sie die Steuerspannung (Vup), die dem ersten absinkenden Ausgangsleistungswert (P) entspricht, in digitaler Form speichern.

17. Kommunikationsempfänger (RFR), der ein Hochfrequenz-Bandpassfilter (RFF) umfasst, das ein Filtermittel (FM) zum Filtern eines Frequenzbandes in Abhängigkeit vom Wert einer angelegten Steuerspannung (Vi) sowie ein steuerbares Energiezuführungsmittel (PSM) zum Anlegen einer Steuerspannung (Vi) an das Filtermittel (FM) umfasst, **dadurch gekennzeichnet, dass** er eine Kalibrierungsvorrichtung (CD) nach irgendeinem der Ansprüche 8 bis 16 umfasst, die mit dem Filtermittel (FM) und dem Energiezuführungsmittel (PSM) gekoppelt ist.

18. Kommunikationseinrichtung (UE), **dadurch gekennzeichnet, dass** sie einen Kommunikationsempfänger (RFR) nach Anspruch 17 umfasst.

## Revendications

1. Procédé d'étalonnage destiné à un filtre passe-bande pour fréquences radioélectriques (RFF) agencé en vue de filtrer une bande de fréquences en fonction de la valeur d'une tension de commande appliquée, le procédé comprenant une première étape dans laquelle on fournit audit filtre (RFF) un signal de test présentant une puissance d'entrée choisie et une fréquence choisie (FLO), une deuxième étape dans laquelle on applique audit filtre (RFF) des tensions de commande successives (Vᵢ) dont les valeurs varient suivant un premier sens et on mesure les valeurs de puissance de sortie correspondantes (Pₒᵤₜ) dudit signal de test au niveau de la sortie dudit filtre (RFF) tant que la valeur de puissance de sortie augmente, atteint une valeur maximale et, ensuite, commence à décroître, puis on enregistre la première valeur de puissance de sortie décroissante (P_{Φ1}) et la tension de commande correspondante (Vup), et une troisième étape dans laquelle on applique audit filtre (RFF) des tensions de commande successives (Vi) dont les valeurs varient suivant un second sens opposé audit premier sens et on mesure les valeurs correspondantes de puissance de sortie du signal de test (Pₒᵤₜ) tant que la valeur de puissance de sortie augmente, atteint ladite valeur maximale et ensuite, commence à décroître vers une dernière valeur de puissance de sortie, puis on détermine une tension de commande (VLO) correspondant à ladite valeur maximale de la puissance de sortie de filtre à la fréquence choisie (FLO) dudit signal de test à partir de la tension de commande enregistrée (Vup) et de la tension de commande (Vdo) appliquée en dernier et correspondant à ladite dernière valeur de puissance de sortie,
**caractérisé en ce que**, pendant ladite troisième étape, la tension de commande (VLO) correspondant à la valeur maximale de la puissance de sortie de filtre au niveau de la fréquence choisie (FLO) du signal de test, est déterminée en ajoutant la tension de commande enregistrée (Vup) à la tension de commande (Vdo) appliquée en dernier et en divisant le résultat de cette somme par 2.

2. Procédé d'étalonnage selon la revendication 1,
**caractérisé en ce que** ledit premier sens correspond à des valeurs successives de tension de commande croissantes (Vi) et ledit second sens correspond à des valeurs successives de tension de commande décroissantes (Vi).

3. Procédé d'étalonnage selon la revendication 1,
**caractérisé en ce que** ledit premier sens correspond à des valeurs successives de tension de commande décroissantes (Vi) et **en ce que** ledit second sens correspond à des valeurs successives de tension de commande croissantes (Vi).

4. Procédé d'étalonnage selon l'une quelconque des revendications 1 à 3, **caractérisé en ce que**, pendant la deuxième étape, on détermine le début de la décroissance de la valeur de puissance de sortie en détectant une inversion du signe d'une variable représentative d'une variation de puissance de sortie, puis on enregistre la première valeur de puissance de sortie décroissante (P_{Φ1}) qui correspond à cette inversion de signe et la tension de commande correspondante (Vup).

5. Procédé d'étalonnage selon la revendication 4,
**caractérisé en ce que**, pendant la deuxième étape, on détermine ladite variable après chaque mesure en soustrayant la précédente valeur de puissance de sortie mesurée (PS₁) de la valeur de puissance de sortie en cours (PS₂) afin d'arrêter l'application d'une nouvelle tension lorsque le résultat d'une soustraction est inférieur à zéro, indiquant ainsi ladite inversion de signe, puis on enregistre la valeur de puissance de sortie mesurée en cours (P_{Φ1}) et la tension de commande correspondante (Vup).

6. Procédé d'étalonnage selon l'une quelconque des revendications 1 à 5, **caractérisé en ce que**, pendant ladite troisième étape, on peut arrêter l'application d'une tension de commande lorsque la valeur de puissance de sortie correspondante appliquée en dernier est égale ou inférieure à la première valeur de puissance de sortie décroissante enregistrée (P_{Φ1}).

7. Procédé d'étalonnage selon l'une quelconque des revendications 1 à 6, **caractérisé en ce que**, pendant ladite troisième étape, on applique des tensions de commande successives (Vi) audit filtre (RFF) en démarrant à partir de la tension de commande enregistrée (Vup).

8. Dispositif d'étalonnage (CD) destiné à un filtre passe-bande pour fréquences radioélectriques (RFF) comportant des moyens de filtre (FM) permettant de filtrer une bande de fréquences, en fonction de la valeur d'une tension de commande appliquée (Vi), et des moyens d'alimentation en puissance pouvant être commandés (PSM) permettant d'appliquer une tension de commande aux dits moyens de filtre (FM), le dispositif comprenant :
i) un générateur (FM) agencé pour fournir aux dits moyens de filtre (GM) un signal de test présentant une puissance d'entrée choisie et une fréquence choisie (FLO),
ii) des moyens de mesure (MM) agencés en vue de mesurer les valeurs de puissance de sortie (Vi) dudit signal de test au niveau de la sortie desdits moyens de filtre (FM), et
iii) des moyens de commande (CM) agencés en vue de :
a) donner l'ordre aux dits moyens d'alimentation en puissance (PSM) d'appliquer aux dits moyens de filtre (FM) des tensions de commande successives (Vi) dont les valeurs varient suivant un premier sens, tant que la valeur de puissance de sortie augmente, atteint une valeur maximale et ensuite commence à décroître, puis
b) enregistrer la première valeur de puissance de sortie décroissante (P1) et la tension de commande correspondante (Vup), puis
c) donner l'ordre aux dits moyens d'alimentation en puissance (PSM) d'appliquer aux dits moyens de filtre (FM) des tensions de commande successives (Vi) dont les valeurs varient suivant un second sens opposé audit premier sens, tant que la valeur de puissance de sortie augmente, atteint ladite valeur maximale et ensuite commence à décroître vers une dernière valeur de puissance de sortie, et alors
d) déterminer une tension de commande (VLO) correspondant à une valeur maximale de la puissance de sortie de filtre au niveau de la fréquence choisie (FLO) dudit signal de test à partir de la tension de commande enregistrée (Vup) et d'une tension de commande (Vdo) appliquée en dernier et correspondant à ladite dernière valeur de puissance de sortie,
**caractérisé en ce que** lesdits moyens de commande (CM) sont agencés en vue de déterminer ladite tension de commande (VLO) correspondant à la valeur maximale de la puissance de sortie de filtre au niveau de la fréquence choisie (FLO) du signal de test, en ajoutant la tension de commande enregistrée (Vup) à la tension de commande (Vdo) appliquée en dernier et en divisant le résultat de cette addition par 2.

9. Dispositif d'étalonnage selon la revendication 8,
**caractérisé en ce que** ledit premier sens correspond à des valeurs successives de tension de commande croissantes (Vi) et ledit second sens correspond à des valeurs successives de tension de commande décroissantes (Vi).

10. Dispositif d'étalonnage selon la revendication 8,
**caractérisé en ce que** ledit premier sens correspond à des valeurs successives de tension de commande décroissantes (Vi) et ledit second sens correspond à des valeurs successives de tension de commande croissantes (Vi).

11. Dispositif d'étalonnage selon l'une quelconque des revendications 8 à 10, **caractérisé en ce que** lesdits moyens de commande (CM) sont agencés afin de déterminer un début de la décroissance de la valeur de puissance de sortie en détectant une inversion du signe d'une variable représentative d'une variation de la puissance de sortie, puis à enregistrer la première valeur de puissance de sortie décroissante (P_{Φ1}) qui correspond à cette inversion de signe et à la tension de commande correspondante (Vup).

12. Dispositif d'étalonnage selon la revendication 11,
**caractérisé en ce que** lesdits moyens de commande (CM) sont agencés en vue de déterminer ladite variable après chaque mesure en soustrayant la valeur de puissance de sortie précédente (PS₁) de la valeur de puissance de sortie en cours (PS₂) pour donner l'ordre aux dits moyens d'alimentation en puissance (PSM) d'arrêter l'application d'une nouvelle tension lorsque le résultat d'une soustraction est inférieur à zéro, indiquant ainsi ladite inversion de signe, puis d'enregistrer la valeur de puissance de sortie en cours (P_{Φ1}) et la tension de commande correspondante (Vup).

13. Dispositif d'étalonnage selon l'une quelconque des revendications 8 à 12, **caractérisé en ce que** lesdits moyens de commande (CM) sont agencés afin de décider d'ordonner aux dits moyens d'alimentation en puissance (PSM) d'arrêter l'application d'une tension de commande aux dits moyens de filtre (FM) lorsque la valeur de puissance de sortie appliquée en dernier et correspondant à la tension de commande appliquée en dernier est égale ou inférieure à la première valeur enregistrée de la puissance de sortie décroissante (P_{Φ1}).

14. Dispositif d'étalonnage selon l'une quelconque des revendications 8 à 13, **caractérisé en ce que** lesdits moyens de commande (CM) sont agencés, pour la dernière détection de la valeur décroissante, en vue d'ordonner aux dits moyens d'alimentatio n en puissance (PS) d'appliquer aux dits moyens de filtre (FM)des tensions de commande successives en démarrant à partir de la tension de commande enregistrée (Vup).

15. Dispositif d'étalonnage selon l'une quelconque des revendications 8 à 14, **caractérisé en ce qu'**il comporte une première mémoire analogique (M1) dans laquelle lesdits moyens de commande (CM) sont agencés pour enregistrer ladite première valeur de puissance de sortie décroissante (P_{Φ1}) sous une forme analogique.

16. Dispositif d'étalonnage selon l'une quelconque des revendications 8 à 15, **caractérisé en ce qu'**il comporte une seconde mémoire numérique (M2) dans laquelle lesdits moyens de commande (CM) sont agencés en vue d'enregistrer ladite tension de commande (Vup) correspondant à la première valeur de puissance de sortie décroissante (P) sous une forme numérique.

17. Récepteur de communication (RFR) comportant un filtre passe-bande pour fréquences radioélectriques (RFF) comprenant des moyens de filtre (FM) pour filtrer une bande de fréquences, en fonction de la valeur d'une tension de commande appliquée (Vi), et des moyens d'alimentation en puissance pouvant être commandés (PSM) permettant d'appliquer une tension de commande (Vi) aux dits moyens de filtre (FM), **caractérisé en ce qu'**il comporte un dispositif d'étalonnage (CD) selon l'une des revendications 8 à 16, couplé aux dits moyens de filtre (FM) et aux dits moyens d'alimentation en puissance (PSM).

18. Equipement de communications (UE) **caractérisé en ce qu'**il comprend un récepteur de communications (RFR) selon la revendication 17.
